# EUROPÄISCHE PATENTSCHRIFT

(11) **EP 2 001 129 B1**
(45) Veröffentlichungstag und Bekanntmachung des Hinweises auf die Patenterteilung: **03.02.2010**
(21) Anmeldenummer: 08008707.5
(22) Anmeldetag: 09.05.2008
(51) Int. Cl.: H03G 1/00

(54) **Signalverarbeitungsvorrichtung und Signalverarbeitungsverfahren**
Signal processing device and method
Dispositif de traitement du signal et procédé de traitement du signal

(30) Priorität: 22.05.2007 DE 102007024013
(43) Veröffentlichungstag der Anmeldung: 10.12.2008
(73) Patentinhaber: Atmel Automotive GmbH, 74072 Heilbronn (DE)
(72) Erfinder: Samid, Lourans, 74072 Heilbronn (DE); Dvorszky, Robert, 74074 Heilbronn (DE); Schwarzmueller, Marco, 74080 Heilbronn (DE); Grosskinsky, Ulrich, 74861 Neudenau (DE)
(74) Vertreter: Müller, Wolf-Christian

(56) Entgegenhaltungen:
- EP-A- 0 926 819
- US-A1- 2002 142 745
- US-B1- 6 195 399

## Beschreibung

Die vorliegende Erfindung bezieht sich auf eine Signalverarbeitungsvorrichtung und ein Signalverarbeitungsverfahren.

Aus der US 2006/0014508 A1 ist eine Schaltung zur Erfassung der Leistung eines Eingangssignals eines Empfängersystems bekannt. Das Empfängersystem weist eine Anzahl von analogen Verstärkern mit automatischer Verstärkungsregelung, einen analogen selektiven Filter mit fester Filtercharakteristik, einen analogen Mischer und Messmittel zur Messung der Leistung eines Ausgangssignals für eine vorbestimmte Frequenz auf. Weiterhin sind Berechnungsmittel zur Ermittlung der Leistung des Eingangssignals, der Verstärkung der Anzahl von analogen Verstärkern und der Verstärkung des analogen selektiven Filters für die vorbestimmte Frequenz anhand einer Kalibrierung von Parametern von Filterfunktionen für verschiedene Frequenzbereiche vorgesehen.

Es ist die Aufgabe der Erfindung eine digitale Signalverarbeitungsvorrichtung beziehungsweise Signalverarbeitungsverfahren möglichst zu vereinfachen.

Diese Aufgabe wird durch die Merkmale der unabhängigen Ansprüche gelöst. Vorteilhafte Weiterbildungen sind Gegenstand von abhängigen Ansprüchen und in der Beschreibung angegeben.

Der Erfindung liegt die Erkenntnis zugrunde, dass die Änderung der Übertragungscharakteristik des Signalverarbeitungselements - insbesondere eines Filters - durch eine Korrektur eines auf der Basis des Ausgangssignals des Signalverarbeitungselements erhaltenen Erfassungswertes, der eine charakteristische Ausgangsgröße, wie z.B. die Leistung, repräsentiert, zumindest teilweise kompensiert werden kann.

Durch die Korrektur des (i.a. skalaren) Erfassungswerts wird eine skalare Größe verarbeitet und nicht beispielsweise das gesamte Ausgangssignal des Signalverarbeitungselements. Jeder vorbestimmten Übertragungscharakteristik können im Vorfeld vorbestimmte Korrekturwerte zugeordnet und z.B. in einer Look-Up-Tabelle abgelegt werden.

Gemäß einem Aspekt schafft die Erfindung eine Signalverarbeitungsvorrichtung mit einem Signalverarbeitungselement mit beispielsweise einstellbaren Filterkoeffizienten für eine einstellbare Übertragungscharakteristik, z.B. einer vorbestimmten Übertragungsfunktion oder einer vorbestimmten Impulsantwort oder einer vorbestimmten Dämpfungscharakteristik oder einer vorbestimmten Verstärkung.

Ferner weist die Signalverarbeitungsvorrichtung eine Beaufschlagungseinrichtung auf, die zur Verstärkung oder Dämpfung eines Ausgangssignals des Filters dem Filter nachgeschaltet ist. Die Beaufschlagungseinrichtung ist ausgebildet einen Einfluss der vorbestimmten Übertragungscharakteristik des Filters auf eine charakteristische Größe eines Eingangssignals teilweise zu kompensieren, wobei die Kompensation mit einem Restfehler behaftet ist.

Ferner umfasst die Signalverarbeitungsvorrichtung eine Erfassungseinrichtung zum Erfassen einer charakteristischen Größe eines Ausgangssignals des Signalverarbeitungselements, wobei die Erfassungseinrichtung ausgebildet ist, einen Erfassungswert auszugeben, der die charakteristische Größe des Ausgangssignals repräsentiert.

Ferner weist die Signalverarbeitungsvorrichtung eine Korrektureinrichtung zum Beaufschlagen des Erfassungswerts mit einem vorbestimmten Korrekturwert zur zumindest teilweisen Kompensation des Restfehlers auf. Der Korrekturwert ist der vorbestimmten Übertragungscharakteristik zugeordnet.

Ferner umfasst die Signalverarbeitungsvorrichtung eine Steuereinrichtung zum Einstellen der vorbestimmten Filterkoeffizienten des Filters, der vorbestimmten Verstärkung oder Dämpfung der Beaufschlagungseinrichtung und des vorbestimmten Korrekturwertes der Korrektureinrichtung.

Gemäß einer Ausführungsform repräsentiert die charakteristische Größe des Ausgangssignals eine charakteristische Größe eines Eingangssignals des Signalverarbeitungselements. Die Korrektureinrichtung ist ferner ausgebildet, den Erfassungswert mit dem vorbestimmten Korrekturwert z.B. durch eine Addition oder Multiplikation zu beaufschlagen, um den Einfluss der vorbestimmten Übertragungscharakteristik auf die charakteristische Größe des Eingangssignals des Signalverarbeitungselements zumindest teilweise zu kompensieren.

Gemäß einer weiteren Ausführungsform ist die charakteristische Größe des Eingangs- oder des Ausgangssignals die Leistung oder die Energie oder die Amplitude oder die Phase.

Gemäß einer weiteren Ausführungsform ist die Erfassungseinrichtung ausgebildet, die charakteristische Größe des Ausgangssignals zu messen. Beispielsweise führt die Erfassungseinrichtung eine RSSI-Messung durch, um die Leistung des Ausgangssignals zu bestimmen.

Gemäß einer weiteren Ausführungsform ist die Steuereinrichtung ausgebildet, die vorbestimmte Übertragungscharakteristik aus einer Mehrzahl von Übertragungscharakteristika auszuwählen, wobei jeder Übertragungscharakteristik der Mehrzahl von Übertragungscharakteristika ein Korrekturwert zugeordnet ist. Die Übertragungscharakteristika, die z.B. durch Filterkoeffizienten oder Koeffizienten einer Impulsantwort bestimmt sind, können z.B. in Form von Koeffizienten in einem Speicher bereitgestellt und aus demselben abgerufen werden.

Gemäß einer weiteren Ausführungsform ist die Steuereinrichtung ausgebildet, den vorbestimmten Korrekturwert, der beispielsweise in einer Look-Up-Tabelle gespeichert sein kann, der Korrektureinrichtung bereitzustellen.

Gemäß einer weiteren Ausführungsform umfasst die Signalverarbeitungseinrichtung ferner eine Beaufschlagungseinrichtung, die dem Signalverarbeitungselement nachgeschaltet ist und dessen Ausgangssignal empfängt. Bevorzugt ist die Beaufschlagungseinrichtung ausgebildet, das Ausgangssignal mit einem vorbestimmten Beaufschlagungswert beispielsweise additiv oder multiplikativ zu beaufschlagen, der der vorbestimmten Übertragungscharakteristik oder dem vorbestimmten Korrekturwert zugeordnet ist, um z.B. den Einfluss der Änderung der Übertragungscharakteristik des Signalverarbeitungselements auf die charakteristische Größe des Ausgangssignals zumindest zu verringern.

Gemäß einer weiteren Ausführungsform ist die Steuereinrichtung ausgebildet, die vorbestimmte Übertragungscharakteristik aus einer Mehrzahl von Übertragungscharakteristika auszuwählen, wobei jeder Übertragungscharakteristik der Mehrzahl von Übertragungscharakteristika ein Beaufschlagungswert zugeordnet ist. Die Beaufschlagungswerte können z.B. in einer Look-Up-Tabelle bereitgestellt werden.

Gemäß einer weiteren Ausführungsform ist die Steuereinrichtung ausgebildet, den vorbestimmten Beaufschlagungswert der Beaufschlagungseinrichtung bereitzustellen.

Gemäß einer weiteren Ausführungsform repräsentiert die charakteristische Größe des Ausgangssignals eine charakteristische Größe eines Eingangssignals des Signalverarbeitungselements, z.B. die Leistung. Die Beaufschlagungseinrichtung ist bevorzugt ausgebildet, das Ausgangssignal mit einem vorbestimmten Beaufschlagungswert zu beaufschlagen, um den Einfluss der vorbestimmten Übertragungscharakteristik auf die charakteristische Größe des Eingangssignals zumindest teilweise zu kompensieren. Die Korrektureinrichtung ist ferner ausgebildet, einen nach der zumindest teilweisen Kompensation verbleibenden Einfluss der vorbestimmten Übertragungsfunktion auf den Erfassungswert durch Beaufschlagung desselben mit dem vorbestimmten Korrekturwert zumindest teilweise zu kompensieren. Durch dieses zweistufige Konzept wird erreicht, dass die Korrekturwerte für die Korrektur des Erfassungswerts gering sind. Der Beaufschlagungswert ist dabei bevorzugt eine Potenz von zwei, z.B. 2^N oder 2^(-N), wobei N z.B. eine natürliche Zahl ist.

Gemäß einer weiteren Ausführungsform ist das Signalverarbeitungselement ein Filter, z.B. ein Bandpassfilter, mit einstellbaren Filterkoeffizienten. Die Steuereinrichtung ändert bevorzugt die Filterkoeffizienten des Filters, um die vorbestimmte Übertragungscharakteristik durch die Einstellung vorbestimmter Filterkoeffizienten einzustellen.

Gemäß einer weiteren Ausführungsform umfasst die Signalverarbeitungseinrichtung ein weiteres Signalverarbeitungselement mit einstellbarer Übertragungscharakteristik, das dem Signalverarbeitungselement vorgeschaltet ist. Zwischen dem weiteren Signalverarbeitungselement und dem Signalverarbeitungselement kann ferner eine weitere Beaufschlagungseinrichtung vorgesehen werden. Dabei ist die Steuereinrichtung ausgebildet, eine weitere vorbestimmte Übertragungscharakteristik des weiteren Signalverarbeitungselements einzustellen. Die Korrektureinrichtung ist bevorzugt ausgebildet, den Erfassungswert mit einem Gesamtkorrekturwert zu beaufschlagen, der eine Überlagerung des vorbestimmten Korrekturwerts, der der vorbestimmten Übertragungscharakteristik zugeordnet ist, und eines weiteren vorbestimmten Faktors, der der weiteren vorbestimmten Übertragungscharakteristik zugeordnet ist, repräsentiert. Hierzu kann die Korrektureinrichtung einen, zwei oder mehrere Addierer aufweisen, die die Korrekturwerte und den Erfassungswert addieren.

Gemäß einem weiteren Aspekt schafft die Erfindung eine Signalverarbeitungsvorrichtung mit einer Erfassungseinrichtung, einem einstellbaren digitalen Filter als Signalverarbeitungselement, einer digitalen Multipliziereinrichtung als Beaufschlagungseinrichtung und einer Korrektureinrichtung.

Die Erfassungseinrichtung ist zum Erfassen einer Signalstärke eines Signals ausgebildet. Dabei repräsentiert ein von der Erfassungseinrichtung ausgebbarer Erfassungswert die Signalstärke des Signals. Eine derartige Signalstärke ist beispielsweise mittels eines RSSI-Wertes darstellbar.

Der einstellbare digitale Filter ist der Erfassungseinrichtung im Signalpfad vorgeschaltet und beeinflusst entsprechend seiner Übertragungscharakteristik das Signal. Filterkoeffizienten zur Einstellung der Übertragungscharakteristik des Filters sind einer Verstärkung oder Dämpfung des Signals durch den Filter zugeordnet. Die Verstärkung oder Dämpfung des Signals ist durch die Filterkoeffizienten dabei vorbestimmt.

Die digitale Multipliziereinrichtung ist zur Verstärkung oder Dämpfung des Signals der Erfassungseinrichtung vorgeschaltet. Die Multipliziereinrichtung ist ausgebildet die Verstärkung oder Dämpfung des Filters lediglich teilweise zu kompensieren. Dabei ist die Kompensation mit einem Restfehler behaftet. Das Signal wird durch die Multipliziervorrichtung vorzugsweise mit dem Faktor 1/(2^N) verstärkt bzw. gedämpft, wobei N eine positive oder negative, ganze Zahl sein kann. Der Restfehler ist dabei durch die Differenz zwischen der Verstärkung bzw. Dämpfung durch den Filter und der angenäherten Verstärkung entsprechend dem Faktor 1/(2^N) der Multipliziervorrichtung bestimmt.

Die Korrektureinrichtung ist zum Beaufschlagen des Erfassungswerts mit einem den Restfehler zumindest teilweise kompensierenden Korrekturwert ausgebildet. Vorzugsweise ist die Korrektureinrichtung für das Beaufschlagen zur Addition von einem logarithmischen Erfassungswert mit einem logarithmischen Korrekturwert ausgebildet.

Ein weiterer Aspekt der Erfindung ist eine Verwendung eines Filters, einer Multipliziereinrichtung und einer Korrektureinrichtung zur Signalverarbeitung.

Gemäß einer vorteilhaften Weiterbildung ist vorgesehen, dass die Dämpfung oder Verstärkung der Multipliziereinrichtung und der Korrekturwert der Korrektureinrichtung vorbestimmt und der vorbestimmten Übertragungscharakteristik des Filters zugeordnet sind. Vorzugsweise sind Werte für die Dämpfung oder Verstärkung und der Korrekturwerte in einer Tabelle abgelegt und der vorbestimmten Übertragungscharakteristik beispielsweise durch Zeiger zugeordnet.

Bevorzugt sind die Dämpfung oder Verstärkung der Multipliziereinrichtung und der Korrekturwert der Korrektureinrichtung und die Übertragungscharakteristik des Filters zusammen durch genau ein Signal steuerbar.

Vorteilhafterweise ist die Multipliziereinrichtung zur Multiplikation des Signals mit einem Faktor als Schieberegister oder als Multiplexer oder als Gatterlogik ausgebildet.

In einer vorteilhaften Ausgestaltung ist der Filter als Bandpassfilter ausgebildet, wobei mittels der Filterkoeffizienten eine Bandbreite als Übertragungscharakteristik des Bandpassfilters einstellbar ist.

Gemäß einem weiteren Aspekt schafft die Erfindung ein Signalverarbeitungsverfahren mit dem Schritt des Verarbeitens eines Signals mittels eines Signalverarbeitungselements, das eine Übertragungscharakteristik aufweist, um ein Ausgangssignal zu erhalten, dem Schritt des Einstellens einer vorbestimmten Übertragungscharakteristik des Signalverarbeitungselements, dem Schritt des Erfassens einer charakteristischen Größe eines Ausgangssignals des Signalverarbeitungselements, dem Schritt des Ausgebens eines Erfassungswerts, der die charakteristische Größe des Ausgangssignals repräsentiert und dem Schritt des Beaufschlagens des Erfassungswerts mit einem vorbestimmten Korrekturwert, der der vorbestimmten Übertragungscharakteristik zugeordnet ist.

Gemäß einer weiteren Ausführungsform umfasst das Signalverarbeitungsverfahren den Schritt des Beaufschlagens des Ausgangssignals des Signalverarbeitungselements mit einem vorbestimmten Beaufschlagungswert, der der vorbestimmten Übertragungscharakteristik oder dem vorbestimmten Korrekturwert zugeordnet ist.

Gemäß einer weiteren Ausführungsform repräsentiert die charakteristische Größe des Ausgangssignals eine charakteristische Größe eines Eingangssignals des Signalverarbeitungselements. Das Ausgangssignal wird mit dem vorbestimmten Beaufschlagungswert bevorzugt beaufschlagt, um den Einfluss der vorbestimmten Übertragungscharakteristik auf die charakteristische Größe des Eingangssignals des Signalverarbeitungselements zumindest teilweise zu kompensieren. Der Erfassungswert wird bevorzugt mit dem vorbestimmten Korrekturwert beaufschlagt, um einen nach der zumindest teilweisen Kompensation verbleibenden Einfluss der vorbestimmten Übertragungsfunktion auf den Erfassungswert zumindest teilweise zu kompensieren.

Weitere Schritte des erfindungsgemäßen Verfahrens ergeben sich direkt aus der Funktionalität der Signalverarbeitungseinrichtung.

Gemäß einem weiteren Aspekt schafft die Erfindung ein Computerprogramm zum Durchführen des erfindungsgemäßen Verfahrens, wenn das Computerprogramm auf einem Computer abläuft.

Gemäß einem weiteren Aspekt schafft die Erfindung eine programmtechnisch eingerichtete Datenverarbeitungsvorrichtung, die ausgebildet ist, das Computerprogramm ablaufen zu lassen, um die Schritte des erfindungsgemäßen Verfahrens auszuführen.

Weitere Ausführungsformen der Erfindung werden Bezug nehmend auf die beiliegenden Zeichnungen erläutert. Es zeigen:
Fig. 1 ein Blockdiagramm einer Signalverarbeitungsvorrichtung; und
Fig. 2 ein Blockdiagramm einer Signalverarbeitungsvorrichtung.

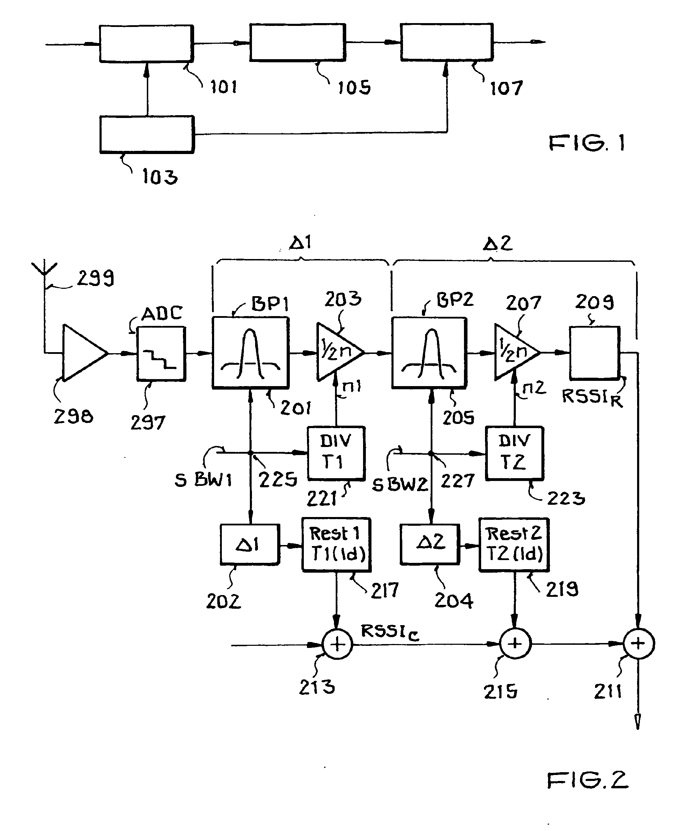

Fig. 1 zeigt ein Blockdiagramm einer Signalverarbeitungsvorrichtung mit einem digitalen Signalverarbeitungsmodul 101, das mindestens ein digitales Signalverarbeitungselement aufweist. Die Signalverarbeitungsvorrichtung weist eine digitale Steuereinrichtung 103 zum Einstellen einer vorbestimmten Übertragungscharakteristik des Signalverarbeitungselements durch z.B. Austausch der Koeffizienten auf, die die Übertragungscharakteristik bestimmen. Ferner weist die Signalverarbeitungsvorrichtung eine digitale Erfassungseinrichtung 105 zum Erfassen einer charakteristischen Größe eines Ausgangssignals des Signalverarbeitungselements 101 und eine Korrektureinrichtung 107 zum Beaufschlagen eines von der Erfassungseinrichtung 105 bereitgestellten Erfassungswerts mit einem vorbestimmten Korrekturwert auf, wobei der Korrekturwert der vorbestimmten Übertragungscharakteristik zugeordnet ist.

Fig. 2 zeigt ein Blockdiagramm einer Signalverarbeitungsvorrichtung mit einem ersten Signalverarbeitungselement 201, dessen Ausgang über eine erste Beaufschlagungseinrichtung 203 mit einem Eingang eines zweiten Signalverarbeitungselements 205 gekoppelt ist. Ein Ausgang des zweiten Signalverarbeitungselements 205 ist über eine zweite Beaufschlagungseinrichtung 207 mit einer Erfassungseinrichtung 209 gekoppelt. Ein Ausgang der Erfassungseinrichtung 209 ist mit einem Eingang eines Addierers 211 einer Korrektureinrichtung gekoppelt.

Die Signalverarbeitungsvorrichtung umfasst ferner einen weiteren (optionalen) Addierer 213, der dem ersten Signalverarbeitungselement 201 zugeordnet ist, und einen weiteren Addierer 215, der dem zweiten Signalverarbeitungselement 205 zugeordnet ist. Der optionale Addierer 213 umfasst einen optionalen Eingang zum Empfangen von weiteren Korrekturwerten, die weiteren Signalverarbeitungselementen (nicht dargestellt) zugeordnet sein können. Ein weiterer Eingang des optionalen Addierers 213 ist mit einem Ausgang eines ersten Speicherelementes 217 verbunden, wobei ein Ausgang des optionalen Addierers 213 mit einem Eingang des weiteren Addierers 215 verbunden ist. Ein weiterer Eingang des weiteren Addierers 215 ist mit einem Ausgang eines zweiten Speicherelementes 219 verbunden. Ein Ausgang des weiteren Addierers 215 ist mit einem weiteren Eingang der Korrektureinrichtung 211 gekoppelt.

Die Signalverarbeitungsvorrichtung umfasst ferner ein drittes Speicherelement 221, das mit einem Steuereingang der ersten Beaufschlagungseinrichtung 203 gekoppelt ist, und ein viertes Speicherelement 223, das mit einem Steuereingang der zweiten Beaufschlagungseinrichtung 207 gekoppelt ist. Ferner sind ein erster Steueranschluss 225 und ein zweiter Steueranschluss 227 vorgesehen. Der erste Steueranschluss 225 ist mit einem Steuereingang des ersten Signalverarbeitungselements 201, über ein Verzögerungselement 202 mit einem Steuereingang des ersten Speicherelements 217 und mit einem Steuereingang des dritten Speicherelements 221 verbunden. Der zweite Steueranschluss 227 ist mit einem Steuereingang des zweiten Signalverarbeitungselements 205, über ein Verzögerungselement 204 mit einem Steuereingang des zweiten Speicherelements 219 und mit einem Steuereingang des vierten Speicherelements 223 verbunden.

Das erste Signalverarbeitungselement 201 und das zweite Signalverarbeitungselement 205 sind Filter (BP1, BP2) mit einstellbaren Koeffizienten, was eine flexible Anpassung der Filtercharakteristik ermöglicht. Der Austausch der Koeffizienten des jeweiligen Filters kann beispielsweise durch Steuersignale s_{BW1}, s_{BW2} initiiert werden, die an die Steueranschlüsse 225 bzw. 227 anlegbar sind. Ansprechend auf ein jeweiliges Steuersignal s_{BW1}, s_{BW2}, das vorzugsweise jeweils die Filterbandbreite bestimmt, werden in dem jeweiligen Filter 201, 205 die dem Inhalt des jeweiligen Steuersignals s_{BW1}, s_{BW2} entsprechenden Koeffizienten eingestellt. Hierzu kann beispielsweise das Filter 201 und/oder das Filter 205 einen Speicher aufweisen, in dem mehrere Koeffizientensätze abgelegt sind.

Die Steuersignale s_{BW1}, s_{BW2} sind auch jeweils an die Speicherelemente 217, 219, 221 und 223 anlegbar, die ansprechend hierauf die der jeweiligen und durch die Koeffizienten festgelegten Filtercharakteristik entsprechenden Faktoren auswählen. Die Speicherelemente 221 und 223 wählen die entsprechenden Beaufschlagungswerte (n1, n2) aus und leiten diese an die jeweilige Beaufschlagungsvorrichtung 203 bzw. 207. Die Beaufschlagungsvorrichtungen 203 bzw. 207 können beispielsweise Verstärkungs- oder Dämpfungselemente sein, die das jeweilige Signal beispielsweise gemäß 1/(2^N) verstärken, wobei N eine positive oder negative, bevorzugt natürliche Zahl sein kann. Beispielsweise sind die Beaufschlagungsvorrichtungen 203 bzw. 207 als Multipliziereinrichtungen ausgebildet. Jede Multipliziereinrichtung 203 bzw. 207 kann als Multiplizierer aufgebildet sein. Bevorzugt ist jede Multipliziereinrichtung 203 bzw. 207 jedoch als Schieberegister, oder Multiplexer oder Gatterlogik ausgebildet. Eine Ausbildung als Schieberegister oder Multiplexer oder Gatterlogik ermöglicht ein einfaches Schieben von Eingangs-Bitwerten bzgl. ihrer Wertigkeit. Dies ist besonders einfach zu realisieren.

Zur Steuerung der Beaufschlagungsvorrichtung 203 bzw. 207 wählen die Speicherelemente 221 und 223 dabei als Beaufschlagungswerte n, n1, n2 die vorstehend genannten Potenzen von zwei, die jeweils unterschiedlich sein können. Die Speicherelemente 221 und 223 können jedoch nur die (positiven und negativen) ganzen Zahlen N auswählen, die jeweils unterschiedlich sein können und diese der jeweiligen Beaufschlagungsvorrichtung 203 bzw. 207 zwecks Verstärkung oder Dämpfung bereitstellen.

Die Steuersignale s_{BW1}, s_{BW2} werden ferner an die Speicherelemente 217 und 219 z.B. jeweils durch das Verzögerungselement 202 bzw. 204 geeignet verzögert weitergeleitet die, ansprechend hierauf, die entsprechenden Korrekturwerte (Rest1, Rest2) in Abhängigkeit von einem von der Verstärkung bzw. Dämpfung von Filter 201 bzw. 205 und Beaufschlagungsvorrichtung 203 bzw. 207 verbleibenden Restfehler auswählen, die für die Addierer 213 und 215 unterschiedlich sein können. Die Speicherelemente 217 und 219 stellen die jeweiligen Korrekturwerte dem jeweiligen Addierer 213 bzw. 215 bereit. Die Addierer 213 und 215 summieren die Korrekturwerte, wobei ein Gesamtkorrekturwert mittels des Addierers 211 als Bestandteil einer Korrekturvorrichtung dem Erfassungswert überlagert wird. Die Korrekturwerte können beispielsweise logarithmische Zahlen zu Basis 1d2 sein. Die jeweiligen Korrekturwerte und die jeweiligen Beaufschlagungswerte bilden beispielsweise jeweils ein vorbestimmtes Faktorpaar, das der jeweiligen Filtercharakteristik des Filters 201 bzw. 205 zugeordnet ist.

Die Erfassungseinrichtung 209 führt beispielsweise eine RSSI-Messung durch, wobei der Erfassungswert RSSI_{R} einem groben RSSI-(Teil-)Messwert entspricht und ebenfalls eine logarithmische Zahl zu Basis 1d2 sein kann. Der Addierer 211 führt die Addition des Erfassungswerts RSSI_{R} mit einem durch die Korrektur ermittelten Teilwert RSSI_{C} durch und gibt einen korrigierten Erfassungswert, - im Ausführungsbeispiel der Fig. 2 einen RSSI-Messwert - aus.

Das erste Steuersignal s_{BW1}, das an den ersten Steueranschluss 225 anlegbar ist, kann dem Speicherelement 217 über ein Verzögerungselement 202 zugeführt werden, dass eine Verzögerung Δ1 bewirkt, die der Verzögerung Δ1 entspricht, die durch die Elemente 201, 203, 205, 207 und 209 bewirkt wird. Das zweite Steuersignal s_{BW2}, das an den zweiten Steueranschluss 227 anlegbar ist, kann dem Speicherelement 219 über ein Verzögerungselement 204 zugeführt werden, dass eine Verzögerung Δ2 bewirkt, die der Verzögerung Δ2 entspricht, die durch die Elemente 205, 207und 209 bewirkt wird.

Zur Erzeugung der an die Steueranschlüsse 225 bzw. 227 anlegbaren Steuersignale s_{BW1}, s_{BW2} kann ferner eine Kontrollvorrichtung (103 in Fig. 1 - in Fig. 2 nicht dargestellt) vorgesehen werden.

Ein über eine Antenne 299 empfangenes Signal wird beispielsweise nach einer Verstärkung mittels eines Verstärkers 298, z.B. eines LNA (Low Noise Amplifier) und einer Analog/Digital Umsetzung durch den Analog-Digital-Umsetzer 297, den jeweiligen Filtern 201 und 205 zugeführt. Am Ausgang des jeweiligen Filters 201 bzw. 205 wird die Verstärkung oder Dämpfung durch das Filter 201 bzw. 205 durch eine Verstärkung beziehungsweise Dämpfung durch die Beaufschlagungsvorrichtung 203 bzw. 207 grob korrigiert, sodass der bei der nachfolgenden RSSI-Messung entstandene Fehler, der durch die jeweilige Filterverstärkung oder Filterdämpfung herbeigeführt wird, grob kompensiert wird.

Der Messwert ist nach der Grobkompensation jedoch mit einem (Rest-)Fehler behaftet, der unter Verwendung der Korrektureinrichtung 211 weiter reduziert werden kann. Hierzu wird ein zum Restfehler korrespondierender Korrekturwert Rest1 bzw. Rest2 aus dem Speicher 217 bzw. 219 ausgegeben. Die Zuordnung des Korrekturwertes Rest1 bzw. Rest2 zur Dämpfung/Verstärkung des Filters 201 bzw. 205 und zur Dämpfung/Verstärkung der Beaufschlagungsvorrichtung 203 bzw. 207 wird durch die vorbestimmten Speicherwerte (Tabellen T1 bzw. T2) und das die Übertragungscharakteristik des Filters 201 bzw. 207 und die Speicherwerte (Tabellen T1 und T1(Id) bzw. T2 und T2(Id)) auswählende Steuersignal s_{BW1} bzw. s_{BW2} bewirkt. Dabei steuert das Steuersignal s_{BW1} bzw. s_{BW2} zu den Filterkoeffizienten korrespondierende Tabellenwerte T1 und T1(Id) für die Beaufschlagungsvorrichtung 203 bzw. 207 und korrespondierende Tabellenwerte T2 und T2(Id) entsprechend dem Restfehler (Rest1, Rest2) für die Korrektureinrichtung 211.

Auf diese Wiese können beliebig viele Filterstufen 201, 205 eingesetzt werden, deren Charakteristika individuell unter Berücksichtigung der Beaufschlagungs- und Korrekturwerte gezielt kompensiert werden können.

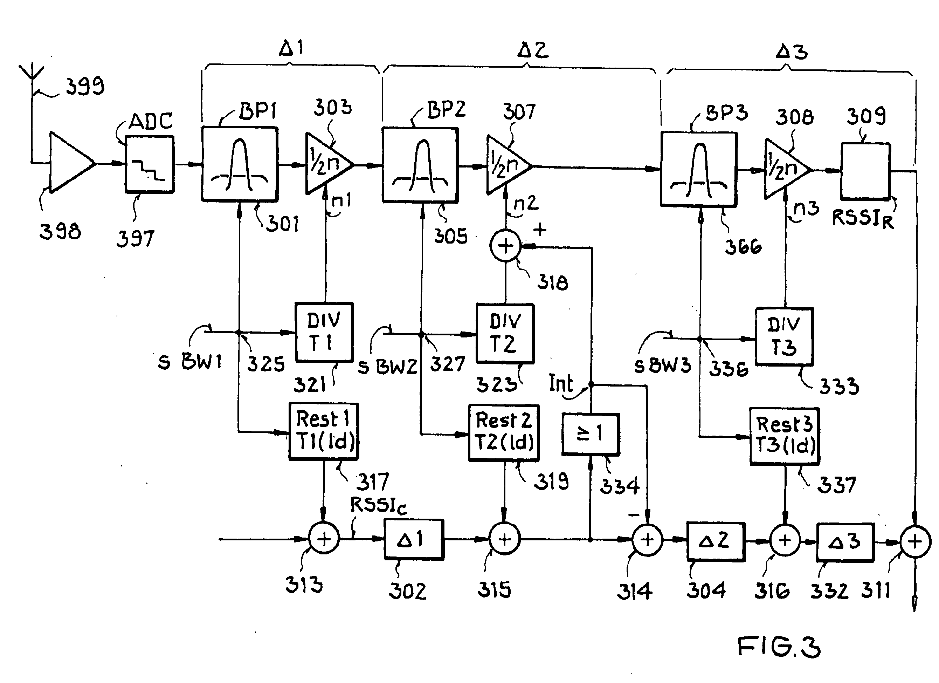

Fig. 3 zeigt ein weiteres Ausführungsbeispiel einer Signalverarbeitungsvorrichtung in Form eines Blockschaltbildes. Die Signalverarbeitungsvorrichtung ist beispielsweise Bestandteil eines Empfängers. Ein empfangenes Signal gelangt über eine Antenne 399 und einen Analogverstärker 398 und einen Analog-Digital-Umsetzer 397 als digitalisiertes Signal zu einer Erfassungseinrichtung 309, der im Signalpfad drei einstellbare Bandpassfilter 301, 305, 366 mit jeweils einer Multipliziereinrichtung 303, 307, 308 vorgeschaltet sind.

Die Erfassungseinrichtung 309 ist zum Erfassen einer Signalstärke des durch die Bandpassfilter 301, 305, 366 gefilterten Signals ausgebildet. Die Erfassungseinrichtung 309 ist ausgebildet, einen Erfassungswert RSSI_{R} auszugeben, der die Signalstärke des gefilterten Signals repräsentiert,

Die digitalen Filter 301, 305, 366 (BP1, BP2, BP3) sind einstellbar ausgebildet, wobei Filterkoeffizienten zur Einstellung einer Übertragungscharakteristik des jeweiligen Filters 301, 305, 366 einer Verstärkung oder Dämpfung des Signals durch den Filter 301, 305, 366 zugeordnet sind. Eine Verstärkung oder Dämpfung lässt sich im Regelfall zur Erzielung einer Bandpass-Übertragungsfunktion nicht vermeiden. Mit Veränderung der Übertragungsfunktion, beispielsweise durch Änderung der Bandbreite des jeweiligen Filters 301, 305, 366 wird zwangsweise aber vorbestimmt auch die Verstärkung oder Dämpfung des Signals im Durchlassbereich geändert.

Um diese Verstärkung oder Dämpfung des Signals durch den jeweiligen Filter 301, 305, 366 möglichst einfach zu kompensieren, sind die Multipliziereinrichtungen vorgesehen. Beträgt beispielsweise die Dämpfung durch den Filter 1/4,2, so kann durch die Multipliziervorrichtung eine Kompensation durch den Faktor 4 erfolgen, so dass die Gesamtdämpfung aus Filter und Multipliziereinrichtung 4/4,2 beträgt. Da die Gesamtdämpfung ungleich 1 ist wird die Dämpfung des Filters nur teilweise kompensiert, es verbleibt ein Restfehler. Die Multipliziereinrichtungen 303, 307, 308 ermöglichen nur eine Verstärkung oder Dämpfung um den Faktor 1/(2ⁿ), wobei n eine ganze Zahl ist. Die Eingänge der Multipliziereinrichtungen 303, 307, 308 werden also ausschließlich mit Signalen n1, n2, n3 für ganze Zahlen gesteuert. Hierdurch ist es möglich die Multipliziereinrichtungen 303, 307, 308 als einfache Schieberegister oder als einfache Multiplexer oder als einfache Gatterlogik auszubilden, die die Bits des Signals entsprechend der Verstärkung bezüglich ihrer Wertigkeit höher und entsprechend der Dämpfung bezüglich ihrer Wertigkeit nach unten schiebt.

Zur aufeinander abgestimmten Einstellung der Filterkoeffizienten und der Verstärkung bzw. Dämpfung durch die jeweilige Multipliziereinrichtung 303, 307, 308 ist jeweils ein Steuersignal s_{BW1}, s_{BW2}, s_{BW3} an einen Steueranschluss 325, 327 beziehungsweise 336 anlegbar. Das Steuersignal s_{BW1} bewirkt ein Auslesen der den Filterkoeffizienten zugeordneten Speicherwerten n1 der Tabelle T1 des Speicherelements 321. Gleichzeitig bewirkt das Steuersignal s_{BW1} ein Auslesen von Korrekturwerten Rest1 aus einer Tabelle T1(Id). Die Speicherelemente 321 und 317 können dabei Einzelspeicher oder feste oder freidefinierbare Bereiche in einem Gesamtspeicher (Flash etc.) sein.

Die Signalverarbeitungsvorrichtung weist eine Korrektureinrichtung zum Beaufschlagen des Erfassungswerts mit einem den Restfehler zumindest teilweise kompensierenden Korrekturwert auf. Die Korrektureinrichtung weist im Ausführungsbeispiel der Fig. 3 einen Addierer 311 zur Addition von logarithmischen Werten auf. Dabei ist das Erfassungswert RSSI_{R} der Erfassungseinrichtung 309 ebenfalls logarithmisch. Der Korrekturwert Rest1 der Tabelle T1(Id) ist ebenfalls logarithmisch und gelangt über den Addierer 313, das Verzögerungselement 302 mit der Verzögerung Δ1, die Addierer 315 und 314, das Verzögerungselement 304 mit der Verzögerung Δ2, den Addierer 316 und das Verzögerungselement 332 mit der Verzögerung Δ3 zum Addierer 311 der Korrektureinrichtung.

Entsprechendes gilt für die Speicherelemente 319, 323, 333 und 337 mit den Tabellen T2, T2 (1d) für den Korrekturwert Rest2 und mit den Tabellen T3 und T3(Id) mit dem Korrekturwert Rest3. Wobei auch diese Korrekturwerte Rest2 und Rest3 zum Addierer 311 der Korrektureinrichtung gelangen. Dabei ist es möglich, dass die Summe der Korrekturwerte Rest1 und Rest2 die Zahl 1 erreichen oder übersteigt. Hierzu ist ein Vergleicher 334 vorgesehen, der die Summe mit der Zahl 1 vergleicht. Erreicht oder übersteigt die Summe die Zahl 1, wird eine ganze Zahl (Integer-Wert) Int mittels des Addierers 318 summiert und erhöht dementsprechend den Faktor n2 der Multipliziereinrichtung 307. Entsprechend wird dieselbe ganze Zahl Int als negativer Wert dem Addierer 314 zugeführt und damit von der Summe der Korrekturwerte Rest1 und Rest2 wieder abgezogen. Dies führt zu dem überraschenden Effekt, dass sowohl die Bitbreite und damit die Chipfläche der Filter 305, 366 und Multipliziereinrichtungen 307, 308 als auch die der Verzögerungsglieder 304, 332 und Addierer 314, 316, 311 minimiert werden kann, ohne die Auflösung zu reduzieren.

Die Einstellung der Koeffizienten der Filter 301, 305, 366 erfolgt vorzugsweise zeitgesteuert und/oder in Abhängigkeit von einem gemessenen Frequenz-Versatz des Signals von einer erwarteten Mittenfrequenz, wobei hierzu die Bandbreite des jeweiligen Filters 301, 305, 366 verringert wird.

Die Erfindung ist dabei nicht auf die dargestellten Ausführungsbeispiele der Figuren 1 bis 3 beschränkt. Beispielsweise ist es möglich eine größere Anzahl von Filterstufen vorzusehen.

### Bezugszeichenliste

- 101: Signalverarbeitungsmodul
- 103: Steuereinrichtung
- 105, 209, 309: Erfassungseinrichtung
- 107, 211, 311: Korrektureinrichtung
- 201, 205, 366, BP1, BP2, BP3: Signalverarbeitungselement, Filter, Bandpassfilter
- 202, 204, 302, 304, 332: Verzögerungselement
- 203, 207, 303, 307, 308: Beaufschlagungseinrichtung, Multipliziereinrichtung, Schieberegister, Multiplexer, Gatterlogik
- 211, 213, 215, 311, 313, 315,314,316,318: Addierer
- 217, 219, 221, 223, 317, 319,321,323,333,337: Speicher
- 225, 227, 325, 327, 336: Steueranschluss
- 297, 397, ADC: Analog-Digital-Umsetzer
- 298, 398: rauscharmer Analog-Verstärker
- 299, 399: Antenne
- 334: Vergleicher
- Δ1, Δ2, Δ3: Verzögerung
- I nt: Integer-Wert
- T1, T2, T3: Tabelle
- Rest1, Rest2, Rest3: Werte für Restfehler
- S_{BW1}, S_{BW2}, S_{BW3}: Steuersignal
- RSSI_{R}: RSSI-Teilwert (grob)
- RSSI_{C}: RSSI-Teilwert (fein)

## Patentansprüche

1. Signalverarbeitungsvorrichtung
- mit einer Erfassungseinrichtung (309) zum Erfassen einer Signalstärke eines Signals, wobei die Erfassungseinrichtung (309) ausgebildet ist, einen Erfassungswert auszugeben, der die Signalstärke des Signals repräsentiert,
- mit einem einstellbaren digitalen Filter (301, 305, 366), der der Erfassungseinrichtung (309) vorgeschaltet ist, wobei Filterkoeffizienten zur Einstellung einer Übertragungscharakteristik des Filters (301, 305, 366) zugeordnet sind einer Verstärkung oder Dämpfung des Signals durch den Filter (301, 305, 366),
- mit einer digitalen Multipliziereinrichtung (303, 307, 308), die zur Verstärkung oder Dämpfung des Signals der Erfassungseinrichtung (309) vorgeschaltet ist, wobei die Multipliziereinrichtung (303, 307, 308) ausgebildet ist die Verstärkung oder Dämpfung des Filters (301, 305, 366) teilweise zu kompensieren, wobei die Kompensation mit einem Restfehler behaftet ist;
und
- mit einer Korrektureinrichtung (311) zum Beaufschlagen des Erfassungswerts mit einem den Restfehler zumindest teilweise kompensierenden Korrekturwert.

2. Signalverarbeitungsvorrichtung nach Anspruch 1, bei der die Dämpfung order Verstärkung der Multipliziereinrichtung (303, 307, 308) und der Korrekturwert der Korrektureinrichtung (311) vorbestimmt und der vorbestimmten Übertragungscharakteristik des Filters (301, 305, 366) zugeordnet sind.

3. Signalverarbeitungsvorrichtung nach Anspruch 1 oder 2, bei der die Dämpfung oder Verstärkung der Multipliziereinrichtung (303, 307, 308) und der Korrekturwert der Korrektureinrichtung (311) und die Übertragungscharakteristik des Filters (301, 305, 366) zusammen durch genau ein Signal steuerbar sind.

4. Signalverarbeitungsvorrichtung nach einem der vorhergehenden Ansprüche, bei der die Multipliziereinrichtung (303, 307, 308) zur Multiplikation des Signals mit einem Faktor als Schieberegister oder als Multiplexer oder als Gatterlogik ausgebildet ist.

5. Signalverarbeitungsvorrichtung nach einem der vorhergehenden Ansprüche, bei der der Filter als Bandpassfilter (301, 305, 366) ausgebildet ist, wobei mittels der Filterkoeffizienten eine Bandbreite als Übertragungscharakteristik des Bandpassfilters (301, 305, 366) einstellbar ist.

6. Signalverarbeitungsvorrichtung, mit:
- einem Filter (201, 205) als Signalverarbeitungselement (101) mit einstellbaren Filterkoeffizienten für eine vorbestimmte Übertragungscharakteristik;
- einer Beaufschlagungseinrichtung (203, 207) zur Verstärkung oder Dämpfung eines Ausgangssignals des Filters (201, 205), wobei die Beaufschlagungseinrichtung (203, 207) ausgebildet ist einen Einfluss der vorbestimmten Übertragungscharakteristik des Filters (201, 205) auf eine charakteristische Größe eines Eingangssignals teilweise zu kompensieren, wobei die Kompensation mit einem Restfehler behaftet ist;
- einer Erfassungseinrichtung (105, 209) zum Erfassen einer die charakteristische Größe des Eingangssignals repräsentierenden charakteristischen Größe eines Ausgangssignals des Signalverarbeitungselements (201, 205), wobei die Erfassungseinrichtung (105, 209) ausgebildet ist, einen Erfassungswert auszugeben, der die charakteristische Größe des Ausgangssignals repräsentiert;
- einer Korrektureinrichtung (107, 211) zum Beaufschlagen des Erfassungswerts mit einem vorbestimmten Korrekturwert zur zumindest teilweisen Kompensation des Restfehlers, wobei der Korrekturwert der vorbestimmten Übertragungscharakteristik zugeordnet ist; und
- einer Steuereinrichtung (103) zum Einstellen der vorbestimmten Filterkoeffizienten des Filters (201, 205), der vorbestimmten Verstärkung oder Dämpfung der Beaufschlagungseinrichtung (203, 207) und des vorbestimmten Korrekturwertes der Korrektureinrichtung (107, 211).

7. Signälverarbeitungsvorrichtung gemäß Anspruch 6, wobei die charakteristische Größe die Leistung oder die Energie oder die Amplitude oder die Phase ist.

8. Signalverarbeitungsvorrichtung gemäß einem der Ansprüche 6 oder 7, wobei die vorbestimmte Übertragungscharakteristik eine vorbestimmte Übertragungsfunktion oder eine vorbestimmte Impulsantwort oder eine vorbestimmte Dämpfungscharakteristik oder eine vorbestimmte Verstärkung ist.

9. Signalverarbeitungsvorrichtung gemäß einem der vorhergehenden Ansprüche, wobei die Steuereinrichtung (103) ausgebildet ist, die vorbestimmte Übertragungscharakteristik aus einer Mehrzahl von Übertragungscharakteristika auszuwählen, wobei jeder Übertragungscharakteristik der Mehrzahl von Übertragungscharakteristika ein Korrekturwert zugeordnet ist und/oder wobei jeder Übertragungscharakteristik der Mehrzahl von Übertragungscharakteristika ein Beaufschlagungswert zugeordnet ist.

10. Signalverarbeitungsvorrichtung gemäß einem der vorhergehenden Ansprüche, wobei der Beaufschlagungswert eine Potenz von zwei ist.

11. Signalverarbeitungsvorrichtung gemäß einem der vorhergehenden Ansprüche, wobei die Korrektureinrichtung ausgebildet ist, den Erfassungswert mit dem Korrekturwert additiv oder multiplikativ zu beaufschlagen.

12. Signalverarbeitungsverfahren, mit:
- Verarbeiten eines Signals mittels eines Filters (201, 205) als Signalverarbeitungselements, wobei der Filter (201, 205) einstellbare Filterkoeffizienten für eine vorbestimmte Übertragungscharakteristik aufweist, um ein Ausgangssignal zu erhalten;
- Einstellen der Filterkoeffizienten des Filters (201, 205);
- Verstärken oder dämpfen des Ausgangssignals mittels einer Beaufschlagungseinrichtung (203, 207), wobei die Beaufschlagungseinrichtung (203, 207) ausgebildet ist einen Einfluss der vorbestimmten Übertragungscharakteristik des Filters (201, 205) auf eine charakteristische Größe eines Eingangssignals teilweise zu kompensieren, wobei die Kompensation mit einem Restfehler behaftet ist;
- Erfassen einer die charakteristische Größe des Eingangssignals repräsentierenden charakteristischen Größe eines Ausgangssignals des Signalverarbeitungselements;
- Ausgeben eines Erfassungswerts, der die charakteristische Größe des Ausgangssignals repräsentiert; und
- Beaufschlagen des Erfassungswerts mit einem vorbestimmten Korrekturwert zur zumindest teilweisen Kompensation des Restfehler, wobei der Korrekturwert, der vorbestimmten Übertragungscharakteristik zugeordnet ist.

13. Computerprogramm zum Durchführen des Verfahrens gemäß Anspruch 12, wenn das Computerprogramm auf einem Computer abläuft.

14. Programmtechnisch eingerichtete Datenverarbeitungsvorrichtung, die ausgebildet ist, das Computerprogramm gemäß Anspruch 13 ablaufen zu lassen, um das Verfahren gemäß Anspruch 12 auszuführen.

15. Verwendung eines einstellbaren digitalen Filters (301, 305, 366), einer digitalen Multipliziereinrichtung (303, 307, 308) und einer Korrektureinrichtung (311) einer Signalverarbeitungsvorrichtung zur Signalverarbeitung
- bei der eine Erfassungseinrichtung (309) zum Erfassen einer Signalstärke eines Signals ausgebildet ist, einen Erfassungswert auszugeben, der die Signalstärke des Signals repräsentiert,
- bei der der einstellbare digitale Filter (301, 305, 366) der Erfassungseinrichtung (309) vorgeschaltet ist, wobei Filterkoeffizienten zur Einstellung einer Übertragungscharakteristik des Filters (301, 305, 366) zugeordnet sind einer Verstärkung oder Dämpfung des Signals durch den Filter (301, 305, 366),
- bei der die digitale Multipliziereinrichtung (303, 307, 308) zu Verstärkung oder Dämpfung des Signals der Erfassungseinrichtung (309) vorgeschaltet ist, wobei die Multipliziereinrichtung (303, 307, 308) ausgebildet ist die Verstärkung oder Dämpfung des Filters (301, 305, 366) teilweise zu kompensieren, wobei die Kompensation mit einem Restfehler behaftet ist;
und
- bei der die Korrektureinrichtung (311) zum Beaufschlagen des Erfassungswerts mit einem den Restfehler zumindest teilweise kompensierenden Korrekturwert ausgebildet ist.

## Claims

1. Signal processing device
- with a detecting device (309) for detecting a signal strength of a signal, wherein the detecting device (309) is constructed to issue a detection value representing the signal strength of the signal,
- with a settable digital filter (301, 305, 366) connected upstream of the detecting device (309), wherein filter coefficients for setting a transmission characteristic of the filter (301, 305, 366) are associated with an amplification or attenuation of the signal by the filter (301, 305, 366),
- with a digital multiplication device (303, 307, 308) which for amplification or attenuation of the signal is connected upstream of the detecting device (309), wherein the multiplication device (303, 307, 308) is constructed to provide partial compensation for the amplification or attenuation of the filter (302, 305, 366), wherein the compensation is subject to a residual error, and
- with a correction device (311) for weighting the detection value with a correction value providing at least partial compensation for the residual error.

2. Signal processing device according to claim 1, in which the attenuation or amplification of the multiplication device (303, 307, 308) and the correction value of the correction device (311) are predetermined and are associated with the predetermined transmission characteristic of the filter (301, 305, 366).

3. Signal processing device according to claim 1 or 2, in which the attenuation or amplification of the multiplication device (303, 307, 308) and the correction value of the correction device (311) and the transmission characteristic of the filter (301, 305, 366) are controllable together by exactly one signal.

4. Signal processing device according to any one of the preceding claims, in which the multiplication device (303, 307, 308) for multiplication of the signal by a factor is constructed as a shift register or as a multiplexer or as a gate logic system.

5. Signal processing device according to any one of the preceding claims, in which the filter is constructed as a bandpass filter (301, 305, 366), wherein a band width as transmission characteristic of the bandpass filter (301, 305, 366) is settable by means of the filter coefficients.

6. Signal processing device with:
- a filter (201, 205) as signal processing element (101) with settable filter coefficients for a predetermined transmission characteristic;
- a loading device (203, 207) for amplification or attenuation of an output signal of the filter (201, 205), wherein the loading device (203, 207) is constructed to provide partial compensation for influence of the predetermined transmission characteristic of the filter (201, 205) on a characteristic magnitude of an input signal, wherein the compensation is subject to a residual error;
- a detecting device (105, 209) for detection of a characteristic magnitude, which represents a characteristic magnitude of the input signal, of an output signal of the signal processing element (201, 205), wherein the detecting device (105, 209) is constructed to issue a detection value representing the characteristic magnitude of the output signal;
- a correction device (107, 211) for weighting the detection value with a predetermined correction value for at least partial compensation of the residual error, wherein the correction value is associated with the predetermined transmission characteristic; and
- a control device (103) for setting the predetermined filter coefficients of the filter (201, 205), the predetermined amplification or attenuation of the loading device (203, 207) and the predetermined correction value of the correction device (107, 211).

7. Signal processing device according to claim 6, wherein the characteristic magnitude is the power or the energy or the amplitude or the phase.

8. Signal processing device according to one of claims 6 and 7, wherein the predetermined transmission characteristic is a predetermined transmission function or a predetermined pulse response or a predetermined attenuation characteristic or a predetermined amplification.

9. Signal processing device according to any one of the preceding claims, wherein the control device (103) is constructed to select the predetermined transmission characteristic from a plurality of transmission characteristics, wherein a correction value is associated with each transmission characteristic of the plurality of transmission characteristics and/or wherein a weighting value is associated with each transmission characteristic of the plurality of transmission characteristics.

10. Signal processing device according to any one of the preceding claims, wherein the weighting value is a power of two.

11. Signal processing device according to any one of the preceding claims, wherein the correction device is constructed to additively or multiplicatively weight the detection value with the correction value.

12. Signal processing method, comprising:
- processing a signal by means of a filter (201, 205) as signal processing element, wherein the filter (201, 205) has settable filter coefficients for a predetermined transmission characteristic in order to obtain an output signal;
- setting the filter coefficients of the filter (201, 205);
- amplifying or attenuating the output signal by means of a loading device (203, 207), wherein the loading device (203, 207) is constructed to provide partial compensation for influence of the predetermined transmission characteristic of the filter (201, 205) on a characteristic magnitude of an input signal, wherein the compensation is subject to a residual error;
- detecting a characteristic magnitude, which represents the characteristic magnitude of the input signal, of an output signal of the signal processing element;
- issuing a detection value representing the characteristic magnitude of the output signal; and
- weighting the detection value with a predetermined value for at least partial compensation for the residual error, wherein the correction value is associated with the predetermined transmission characteristic.

13. Computer program for performance of a method according to claim 12 when the computer program is executed on a computer.

14. Data processing device which is program-equipped and which is constructed to allow execution of the computer program according to claim 13 in order to perform the method according to claim 12.

15. Use of a settable digital filter (301, 305, 366), a digital multiplication device (303, 307, 308) and a correction device (311) of a signal processing device for signal processing,
- in which a detecting device (309) for detection of a signal strength of a signal is constructed issue a detection value representing the signal strength of the signal,
- in which the settable digital filter (301, 305, 366) is upstream of the detecting device (309), wherein filter coefficients or setting a transmission characteristic of the filter (301, 305, 366) are allocated to an amplification or attenuation of the signal by the filter (301, 305, 366),
- in which the digital multiplication device (303, 307, 308) for amplification or attenuation of the signal is upstream of the detecting device (309), wherein the multiplication device (303, 307, 308) is constructed to provide partial compensation for the amplification or attenuation of the filter (301, 305, 366), wherein the compensation is subject to a residual error, and
- in which the correction device (311) is constructed for weighting the detection value with a correction value providing at least partial compensation for the residual error.

## Revendications

1. Dispositif de traitement de signal comprenant :
. une unité de détection (309) pour détecter l'amplitude d'un signal, en ce que l'unité de détection (309) est configurée pour délivrer une valeur de détection qui représente l'amplitude du signal;
. un filtre numérique réglable (301, 305, 366) qui est inséré en amont dans le circuit, en ce que des coefficients de filtrage sont prévus pour le réglage d'une caractéristique de transfert du filtre (301, 305, 366) pour une amplification ou une atténuation du signal à travers le filtre (301, 305, 366)
. une unité numérique de multiplication(303, 307, 308) qui est prévue en amont dans le circuit pour amplifier ou atténuer le signal de l'unité de détection (309), en ce que l'unité de multiplication (303, 307, 308) est configurée pour compenser partiellement l'amplification et en ce que la compensation est modifiée par une valeur résiduelle,
et
. une unité de correction (311) pour appliquer à la valeur de détection une valeur de correction destinée à compenser au moins partiellement la valeur résiduelle.

2. Dispositif de traitement de signal selon la revendication 1 dans lequel l'atténuation ou l'amplification de l'unité de multiplication (303, 307, 308) et la valeur de correction de l'unité de correction (311) sont prédéfinies et assignées à la caractéristique prédéfinie de transfert du filtre (301, 305, 366).

3. Dispositif de traitement de signal selon la revendication 1 ou 2 dans lequel l'atténuation ou l'amplification de l'unité de multiplication (303, 307, 308) et la valeur de correction de l'unité de correction (311) et la caractéristique de transfert du filtre (301, 305, 366) sont commandées ensemble par un seul signal.

4. Dispositif de traitement de signal selon l'une des revendications précédentes dans lequel l'unité de multiplication (303, 307, 308) pour la multiplication du signal est configurée comme un facteur de registre à décalage ou de multiplexeur ou à portes logiques.

5. Dispositif de traitement de signal selon l'une des revendications précédentes dans lequel le filtre est du type passe bande (301, 305, 366), et dans lequel au moyen des coefficients de filtrage on peut établir une bande passante par la caractéristique de transfert du filtre passe bande (301, 305, 366).

6. Dispositif de traitement du signal comprenant :
. un filtre (201, 205) en tant qu'élément de traitement du signal (101) avec des coefficients de filtre réglables pour une caractéristique de transfert prédéterminée;
. un dispositif d'alimentation (203, 207) pour l'amplification ou l'amortissement d'un signal de sortie du filtre (201, 205) dans lequel le dispositif d'alimentation (203, 207) est configuré pour compenser partiellement une influence de la caractéristique prédéfinie de transfert du filtre (201, 205) à partir d'une grandeur caractéristique d'un signal d'entrée, dans lequel la compensation est entaché d'une valeur résiduelle;
. un dispositif de détection (105, 209) pour détecter une des valeurs caractéristiques d'un signal de sortie de l'élément de traitement de signal (201, 205) représentant la valeur caractéristique du signal d'entrée, dans lequel le dispositif de détection (105, 209) est configuré pour délivrer une valeur détectée qui représente la valeur caractéristique du signal de sortie;
. un dispositif de correction (107, 211) pour appliquer la valeur détectée à une valeur de correction prédéterminée en vue de compenser au moins partiellement la valeur résiduelle, dans lequel la valeur de correction de la caractéristique prédéterminée de transfert est prévue; et
. un dispositif de commande (103) pour établir le coefficient prédéterminé de filtre (201, 205) d'amplification ou d'atténuation prédéterminée du dispositif d'application (203, 207) ainsi que la valeur prédéterminée de correction du dispositif de correction (107, 211).

7. Dispositif de traitement du signal selon la revendication 6 dans lequel la valeur caractéristique est la puissance ou l'énergie ou l'amplitude ou la phase.

8. Dispositif de traitement du signal selon la revendication 6 ou 7 dans lequel la grandeur caractéristique de transfert est une fonction de transfert prédéterminée ou une réponse impulsionnelle ou une caractéristique prédéterminée d'atténuation ou d'amplification prédéterminée.

9. Dispositif de traitement du signal selon l'une quelconque des revendications précédentes dans lequel le dispositif de commande (103) est configuré pour sélectionner une caractéristique de transfert parmi une pluralité de caractéristiques de transfert, dans lequel il est prévu pour chaque caractéristique de transfert de cette pluralité de caractéristique de transfert une valeur de correction et/ou il est prévu pour chaque caractéristique de transfert de cette pluralité de caractéristique de transfert une valeur d'application.

10. Dispositif de traitement du signal selon l'une quelconque des revendications précédentes dans lequel la valeur d'application est de puissance 2.

11. Dispositif de traitement du signal selon l'une quelconque des revendications précédentes dans lequel le dispositif de correction est configuré pour additionner ou multiplier la valeur de détection et la valeur de correction.

12. Procédé de traitement du signal avec
. traitement d'un signal au moyen d'un filtre (201, 205) en tant qu'élément de traitement du signal, dans lequel le filtre (201, 205) présente des coefficients réglables de filtrage pour une caractéristique prédéterminée de transfert pour l'obtention d'un signal de sortie;
. réglage des coefficients de filtrage du filtre (201, 205);
. amplification ou atténuation du signal de sortie au moyen d'un dispositif d'application (203, 207) dans lequel le dispositif (203, 207) est configuré pour influencer la caractéristique prédéterminée de transfert du filtre (201, 205) et la compenser partiellement à partie d'une grandeur caractéristique d'un signal d'entrée, dans lequel la compensation est modifiée par une valeur résiduelle;
. détecter une valeur caractéristique d'un signal de sortie représentant la valeur caractéristique du signal d'entrée de l'élément de traitement du signal;
. délivrer une valeur de détection , qui représente la valeur caractéristique du signal de sortie;
. appliquer la valeur de détection avec une valeur de correction prédéterminée pour au moins compenser partiellement la valeur résiduelle dans lequel la valeur de correction est adjointe à la caractéristique prédéterminée de transfert.

13. Programme d'ordinateur pour la mise en oeuvre du procédé selon la revendication 12 lorsque le programme d'ordinateur se déroule sur un ordinateur.

14. Dispositif de traitement de données programmable configuré pour fonctionner avec le programme d'ordinateur selon la revendication 13, pour mettre en oeuvre le procédé selon la revendication 12.

15. Utilisation d'un filtre numérique réglable (301, 305, 366) d'un dispositif numérique de multiplication (303, 307, 308) et d'un dispositif de correction (311) d'un dispositif de traitement du signal pour traiter le signal
. dans lequel un dispositif de détection pour détecter l'amplitude d'un signal est configuré pour délivrer une valeur de détection qui représente l'intensité du signal,
. dans lequel un filtre numérique réglable (301, 305, 366) inséré en amont dans le circuit d'un dispositif de détection (309) dans lequel les coefficients de filtrage pour le réglage d'une caractéristique de transfert du filtre (301, 305, 366) sont adjointes à une amplification ou à une atténuation du signal au moyen du filtre (301, 305, 366),
. dans lequel le dispositif numérique de multiplication (303, 307, 308) pour l'amplification ou l'atténuation du signal du dispositif de détection (309) est monté en amont, dans lequel le dispositif de multiplication (303, 307, 308) est configuré pour compenser partiellement l'amplification ou l'atténuation du filtre (301, 305, 366) et dans lequel la compensation est modifiée par une valeur résiduelle;
et
. dans lequel le dispositif de correction (311) est configuré pour appliquer la valeur de détection à une valeur de correction compensée au moins partiellement par la valeur résiduelle.
